# EUROPEAN PATENT APPLICATION

(11) **EP 3 070 784 A1**
(43) Date of publication of application: **21.09.2016**
(21) Application number: 16160281.8
(22) Date of filing: 15.03.2016
(51) Int. Cl.: H01Q 1/32, H01Q 1/38, H01Q 1/42, H01Q 1/52, H05K 5/00, H05K 5/02, H05K 1/02, H05K 7/20, G01S 7/03, G01S 7/02, G01S 13/93

(54) **VEHICLE RADAR APPARATUS**

(30) Priority: 18.03.2015 JP 2015054609
(71) Applicant: Toyota Jidosha Kabushiki Kaisha, Toyota-shi, Aichi 471-8571 (JP)
(72) Inventor: MINAMI, Yoshiaki, Aichi-Ken, Aichi 471-8571 (JP)
(74) Representative: D Young & Co LLP

(57) **Abstract**

A vehicle radar apparatus includes an antenna board provided with an antenna unit configured to transmit and receive a radio wave on one side surface, a high-frequency circuit being provided on the surface of the antenna board and configured to generate the radio wave to be transmitted and perform processing of the received radar wave, and a case configured to accommodate the antenna board and the high-frequency circuit. The case includes a cover portion that is provided so as to cover the surface side of the antenna board. The cover portion includes a transmission portion configured to transmit the radio wave, and a heat conduction portion having a thermal conductivity higher than a thermal conductivity of the transmission portion. The heat conduction portion is configured to be in contact with the high-frequency circuit directly or via an indirect member having a thermal conductivity higher than the thermal conductivity of the transmission portion.

## Description

### TECHNICAL FIELD

The present invention relates to a vehicle radar apparatus.

### BACKGROUND

In the related art, a vehicle radar apparatus that includes an antenna board provided with an antenna unit configured to transmit and receive a radio wave on one side surface, a high-frequency circuit that performs the generation and processing of the radar wave, and a case that accommodates the antenna board and the high-frequency circuit, is known. The case includes a cover portion that is provided so as to cover the antenna board and a front face thereof.

In the vehicle radar apparatus described above, in order to reduce a power supply loss between the antenna unit and the high-frequency circuit, a configuration in which the high-frequency circuit is mounted on the same surface as the antenna board can be considered. In this configuration, there is a possibility that heat generated from the high-frequency circuit cannot be sufficiently radiated due to the presence of the cover portion. Therefore, for example, as disclosed in Japanese Unexamined Patent Application Publication No. 2005-26368, there is a case where heat conduction via holes (heat radiation via holes) that penetrate the antenna board from a front surface to a rear surface are provided to let the heat escape to the rear surface side of the antenna board.

### SUMMARY

In the related art described above, the heat radiation performance is determined depending on the cross-sectional area of the heat conduction via holes. However, there is a case where the cross-sectional area cannot be sufficiently secured due to constraints such as the surface area of the antenna board. Therefore, in the technology in the related art described above, it is difficult to improve the heat radiation performance.

The object of the present invention is to provide a vehicle radar apparatus in which the heat radiation performance can be improved.

A vehicle radar apparatus according to the present invention includes an antenna board provided with an antenna unit configured to transmit and receive a radio wave on one side surface; a high-frequency circuit provided on said side surface of the antenna board and configured to generate the radio wave to be transmitted and perform processing of the received radio wave; and a case configured to accommodate the antenna board and the high-frequency circuit. The case includes a cover portion that is provided so as to cover said side surface of the antenna board, and the cover portion includes a transmission portion configured to transmit the radio wave, and a heat conduction portion having a thermal conductivity higher than a thermal conductivity of the transmission portion. The heat conduction portion is configured to be in contact with the high-frequency circuit directly or via an indirect member having a thermal conductivity higher than the thermal conductivity of the transmission portion.

In the vehicle radar apparatus, the heat conduction portion of the cover portion is in contact with the high-frequency circuit directly or via the indirect member, and the heat conduction portion and the high-frequency circuit are thermally connected to each other. The heat from the high-frequency circuit can be transferred to the heat conduction portion of the cover portion, and thus, it is possible to radiate the heat outside of the case. In this way, it is possible to improve the heat radiation performance.

In the vehicle radar apparatus according to the present invention, the heat conduction portion may be electrically connected to a ground of the antenna board. In this case, the heat conduction portion which is in contact with the high-frequency circuit can be electrically connected to the ground, and thus, it is possible to cause the heat conduction portion to be grounded.

### BRIEF DESCRIPTION OF THE DRAWINGS

FIG. 1 is a schematic cross-sectional diagram illustrating a vehicle radar apparatus in a first embodiment.
FIG. 2 is a front view illustrating a cover portion of the vehicle radar apparatus in FIG. 1.
FIG. 3 is a schematic cross-sectional diagram illustrating a modification example of the vehicle radar apparatus in FIG. 1.
FIG. 4 is a schematic cross-sectional diagram illustrating a vehicle radar apparatus in a second embodiment.

### DETAILED DESCRIPTION

Hereinafter, embodiments of the present invention will be described in detail with reference to the drawings. In the description below, the same reference signs will be given to the same or similar elements, and the descriptions thereof will not be repeated.

### [First Embodiment]

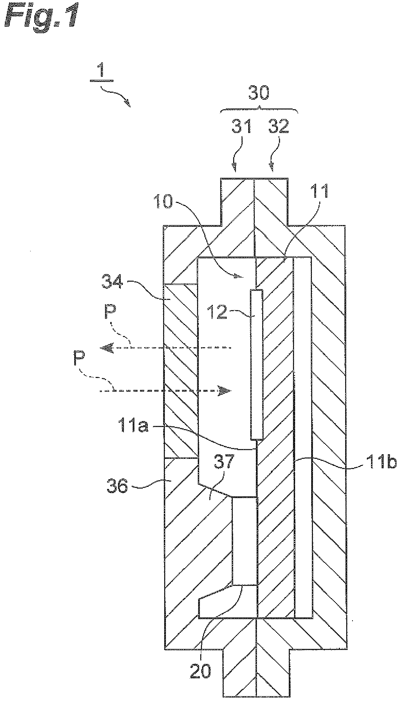

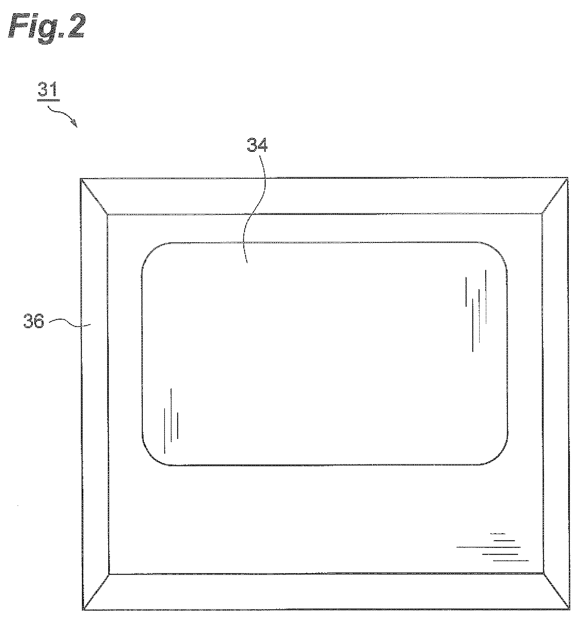

FIG. 1 is a schematic cross-sectional diagram illustrating a vehicle radar apparatus in a first embodiment. FIG. 2 is a front view illustrating a cover portion of the vehicle radar apparatus in FIG. 1. As illustrated in FIG. 1 and FIG. 2, a vehicle radar apparatus 1 is mounted on a vehicle such as an automobile. The vehicle radar apparatus 1 is a radar apparatus applied to, for example, an autonomous travel system or a safety system. The vehicle radar apparatus 1 is applied to an obstacle recognition system or the like that recognizes obstacles around the vehicle. The usage of the vehicle radar apparatus 1 is not limited, and the vehicle radar apparatus 1 can be applied to various usages.

The vehicle radar apparatus 1 transmits a radio wave to the surroundings of the vehicle, receives a reflected radio wave, and recognizes the surroundings of the vehicle. The vehicle radar apparatus 1 transmits the radio wave toward a target object including an obstacle and a moving obstacle and receives the radio wave reflected from the target object, and then, detects at least any of a distance or a direction to the target object. The vehicle radar apparatus 1 may be a front radar apparatus that recognizes the foward direction of the vehicle, may be a rear radar apparatus that recognizes the rearward direction of the vehicle, or may be a side radar apparatus that recognizes the side direction of the vehicle. A millimeter-wave radar apparatus or a microwave radar apparatus can be exemplified as the vehicle radar apparatus 1. The vehicle radar apparatus 1 is disposed, for example, on an emblem, on a grill cover, or on a bumper.

The vehicle radar apparatus 1 includes an antenna board 10, a high-frequency circuit 20, and a case 30. The antenna board 10 includes a substrate 11 and an antenna unit 12. The substrate 11 has a planar shape including a front surface 11a and a rear surface 11b. For example, the structure, shape, material, and type of the substrate 11 are not limited. A known substrate can be used as the substrate 11. The antenna unit 12 is provided on the front surface 11a of the substrate 11. The antenna unit 12 transmits and receives a radio wave P. The antenna unit 12 transmits the radio wave P away from the front surface 11a. The antenna unit 12 receives the radio wave P reflected from the target object. The antenna unit 12 is a planar antenna for use in vehicles. For example, a micro-strip array antenna can be used as the antenna unit 12. For example, the structure, shape, material, and type of the antenna unit 12 are not limited. A known antenna can used as the antenna unit 12. Hereinafter, description will be made under the assumption that the transmission direction of the radio wave P is the forward direction and the direction opposite thereto is the rearward direction.

The high-frequency circuit 20 is provided on the front surface 11a of the antenna board 10. That is, the antenna unit 12 and the high-frequency circuit 20 are provided on the same front surface 11a. The high-frequency circuit 20 is disposed at a position separate (i.e. spaced apart) from the antenna unit 12 on the front surface 11a. The high-frequency circuit 20 is electrically connected to the antenna unit 12. The high-frequency circuit 20 generates the radio wave P which will be transmitted from the antenna unit 12. The high-frequency circuit 20 performs processing of the radio wave P received from the antenna unit 12. A monolithic microwave integrated circuit (MMIC) can be an example of the high-frequency circuit 20. The high-frequency circuit 20 is not limited to a MMIC, but may be a discrete semiconductor active element and a circuit element which are not integrated.

The case 30 accommodates the antenna board 10 and the high-frequency circuit 20 therein. The case 30 includes a cover portion 31 and a case main body 32. The case main body 32 has a shape which opens toward the foward direction. The case main body 32 is provided so as to cover the rear surface 11b side of the antenna board 10. The antenna board 10 is disposed in the case main body 32. The case main body 32 fixes and holds the antenna board 10. A shape of the case main body 32 is not limited, but can be a variety of shapes.

The cover portion 31 has a shape which opens toward the rearward direction. The cover portion 31 is provides so as to cover the front surface 11 a side of the antenna board 10. The cover portion 31 is fixed to the front side of the case main body 32. The cover portion 31 closes the inside of the case main body 32 from the front side. A shape of the cover portion 31 is not limited, but can be a variety of shapes.

The cover portion 31 defines a radome that protects the antenna unit 12 in the structure. The cover portion 31 includes a transmission portion 34 and a heat conduction portion 36. The transmission portion 34 transmits the radio wave P. The transmission portion 34 is provided on at least a part facing the antenna unit 12 in the front-rearward direction. When viewed from the front, the transmission portion 34 overlaps the entire region of the antenna unit 12. The transmission portion 34 is, for example, formed of acrylonitrile butadiene styrene (ABS) resin. The transmission portion 34 has a higher permeability to transmission of the radio wave P than the heat conduction portion 36. The transmission portion 34 may be formed of another material as long as the material transmits the radio wave P.

The heat conduction portion 36 is provided at a position other than the position of the transmission portion 34 on the cover portion 31. The heat conduction portion 36 has a thermal conductivity higher than a thermal conductivity of the transmission portion 34. The heat conduction portion 36 is formed integrally with the transmission portion 34. The heat conduction portion 36 is formed of, for example, a metal such as aluminum. The heat conduction portion 36 may be formed of another material as long as the material has a thermal conductivity higher than the thermal conductivity of the transmission portion 34. For example, the heat conduction portion 36 may be formed of resin. For example, the heat conduction portion 36 may be formed of resin on which a metal having a thermal conductivity higher than the thermal conductivity of the transmission portion 34 is dispersed. For example, the heat conduction portion 36 may be formed of resin on which filler (particles) of metal oxide having a thermal conductivity higher than the thermal conductivity of the transmission portion 34 are dispersed. The thermal conductivity [W/(m· K)] is a physical quantity that defines a magnitude of a heat flux to be conveyed along a gradient in a case where there is a temperature gradient in a medium regarding heat conduction. When there is 1degree of temperature difference (temperature gradient) between both ends of a material having one meter thickness, the thermal conductivity is a heat quantity flowing through a unit area of the material per one second. It means that the heat is more easily transferred as the thermal conductivity increases. The thermal conductivity is also referred to as thermal conductance.

The heat conduction portion 36 is in contact with the high-frequency circuit 20. The heat conduction portion 36 is thermally connected to the high-frequency circuit 20. Specifically, the heat conduction portion 36 has a protruding portion 37 that protrudes toward the rearward direction (inside) at the portion facing the high-frequency circuit 20 in the front-rearward direction. A front end surface (rear end surface) of the protruding portion 37 abuts on (comes into contact with) the high-frequency circuit 20. In the illustrated example, the front end surface of the protruding portion 37 is in contact with the entire front region of a package of the high-frequency circuit 20.

The transmission portion 34 and the heat conduction portion 36 are molded in a two-color molding (double molding) which is an integral molding method in which different materials are combined with each other. In molding the transmission portion 34 and the heat conduction portion 36, for example, insert molding or outsert molding is used. In this way, a structure of bonding the transmission portion 34 and the heat conduction portion 36 is rendered unnecessary, and thus, it is possible to easily ensure the air-tightness of the case 30.

In the vehicle radar apparatus 1, the radio wave P transmitted toward the forward direction from the antenna unit 12 of the antenna board 10 is transmitted through the transmission portion 34 of the cover portion 31, and then, is emitted to the outside of the case 30. The radio wave P reflected from the target object is transmitted through the transmission portion 34 of the cover portion 31 and is incident on the inside of the case 30, and then, is received by the antenna unit 12.

In the vehicle radar apparatus 1 configured as described above, the heat conduction portion 36 of the cover portion 31 is in contact with the high-frequency circuit 20, and the heat conduction portion 36 and the high-frequency circuit 20 are thermally connected to each other. In this way, the heat from the high-frequency circuit 20 can be transferred to the heat conduction portion 36 of the cover portion 31, and thus, it is possible to radiate the heat outside of the case 30, eventually to outside of the vehicle. In the vehicle radar apparatus 1, it is possible to improve the heat radiation performance which is a performance of radiating the heat. In other words, it is possible to realize a high-efficiency thermal exhaust performance.

In the vehicle radar apparatus 1, not only the antenna unit 12 but also the high-frequency circuit 20 are provided on the front surface 11a of the substrate 11 of the antenna board 10. Since the antenna unit 12 and the high-frequency circuit 20 are provided on the same front surface 11a, a length of the power supply circuit from the high-frequency circuit 20 to the antenna unit 12 can be made shorter than that in the configuration of providing the high-frequency circuit 20 on the rear surface 11b of the substrate 11, and thus, it is possible to suppress the power supply loss.

The vehicle radar apparatus 1 may further include a structure on the substrate 11, in which the heat in the high-frequency circuit 20 escapes to the rear surface 11b side of the substrate 11 through the heat conduction via holes that penetrate from the front surface 11a to the rear surface. The heat conduction via hole may be a conformal via hole of which the inner surface is plated or may be a filled via hole of which the hole is plated so as to be closed (filled). In this case, it is possible to further improve the heat radiation performance of the vehicle radar apparatus 1.

Incidentally, in the vehicle radar apparatus 1, the heat from the high-frequency circuit 20 can be radiated at the heat conduction portion 36 of the cover portion 31. Therefore, in a case where the heat conduction via holes for improving the heat radiation performance are provided, it is possible to reduce the number of heat conduction via holes compared to the case where only the heat conduction via holes are provided without including the heat conduction portion 36 and to reduce the diameter of the heat conduction via holes. Accordingly, it is possible to suppress the constraints generated on the surface area of the antenna board 10.

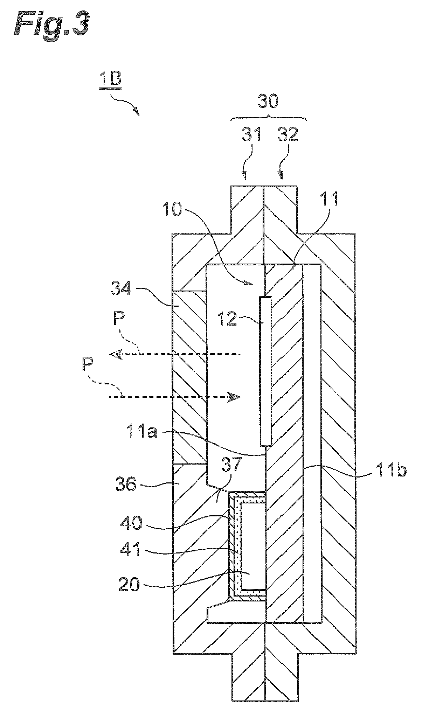

FIG. 3 is a schematic cross-sectional diagram illustrating a vehicle radar apparatus 1B in a modification example. As illustrated in FIG. 3, the vehicle radar apparatus 1B is different from the vehicle radar apparatus 1 (refer to FIG. 1) in that the vehicle radar apparatus 1B includes a circuit case 40 that electromagnetically shields the high-frequency circuit 20 and a heat conductive material 41 that fills the circuit case 40.

The circuit case 40 is provided on the front surface 11a of the substrate 11. The circuit case 40 surrounds the high-frequency circuit 20. The illustrated circuit case 40 has a rectangular box shape. The circuit case 40 has a thermal conductivity higher than the thermal conductivity of the transmission portion 34. The circuit case 40 is formed of a metal such as iron or stainless steel. The circuit case 40 may be formed of another material as long as the thermal conductivity thereof is higher than the thermal conductivity of the transmission portion 34. For example, the circuit case 40 may be formed of resin on which fillers of metal or metal oxide having a thermal conductivity higher than the thermal conductivity of the transmission portion 34 are dispersed.

A gap between the circuit case 40 and the high-frequency circuit 20 is filled with the heat conductive material 41. The heat conductive material 41 is, for example, thermally conductive gel. The heat conductive material 41 may be another material including a gas such as air.

The heat conduction portion 36 of the cover portion 31 is in contact with the high-frequency circuit 20 via the circuit case 40 and the heat conductive material 41. The heat conduction portion 36 is thermally connected to the high-frequency circuit 20 via the circuit case 40 and the heat conductive material 41. The front end surface of the protruding portion 37 of the heat conduction portion 36 abuts on the circuit case 40. In the illustrated example, the front end surface of the protruding portion 37 is in contact with the front surface of the circuit case 40.

According to the vehicle radar apparatus 1B, the heat from the high-frequency circuit 20 can be transferred to the heat conduction portion 36 via the circuit case 40 and the heat conductive material 41, and thus, it is possible to radiate the heat outside of the case 30. In this way, it is possible to improve the heat radiation performance. In the vehicle radar apparatus 1B, the circuit case 40 and the heat conductive material 41 form an indirect member. According to the circuit case 40 and the heat conductive material 41, in addition to transferring the heat to the heat conduction portion 36, a noise that extends to the high-frequency circuit 20 can be shielded and reduced.

In the vehicle radar apparatus 1 and the vehicle radar apparatus 1B, the heat conduction portion 36 (protruding portion 37) may be in contact with the high-frequency circuit 20 via a heat conductive sheet that has a thermal conductivity higher than the thermal conductivity of the transmission portion 34. In this case, the heat conductive sheet forms the indirect member. Instead of or in addition to this, the heat conduction portion 36 may be in contact with the high-frequency circuit 20 via heat conductive grease such as silicone grease which has a thermal conductivity higher than the thermal conductivity of the transmission portion 34. In this case, the heat conductive grease forms at least part ofthe indirect member.

### [Second Embodiment]

Next, a vehicle radar apparatus in a second embodiment will be described. Hereinafter, the description which is the same as that in the first embodiment described above will not be repeated.

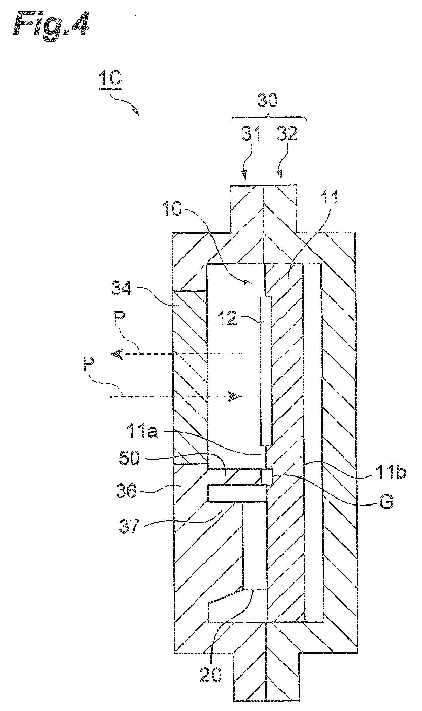

FIG. 4 is a schematic cross-sectional diagram of a vehicle radar apparatus 1C in the second embodiment. As illustrated in FIG. 4, the vehicle radar apparatus 1C is different from the vehicle radar apparatus 1 (refer to FIG. 1) in that the antenna board 10 has a ground G and the heat conduction portion 36 is electrically connected to the ground G.

The ground G is a metal portion for grounding (earthing) the antenna board and the heat conduction portion. The ground G is a conductor having a reference electric potential in the antenna board 10. The ground G is provided on the front surface 11a of the substrate 11. The heat conduction portion 36 has a protruding portion 50 at a part facing the ground G in the front-rearward direction, which protrudes to the rearward direction. The front end surface (rear end surface) of the protruding portion 50 abuts on the ground G.

As described above, in the vehicle radar apparatus 1C also, the heat from the high-frequency circuit 20 can be transferred to the heat conduction portion 36 of the cover portion 31, and thus, it is possible to radiate the heat outside of the case 30. Therefore, it is possible to improve the heat radiation performance. In addition, in the vehicle radar apparatus 1C, it is possible to cause the heat conduction portion 36 which is in contact with the high-frequency circuit 20 to be electrically connected to the ground G of the antenna board 10, and then, cause the heat conduction portion 36 to be grounded.

The embodiments of the present invention are described as above. However, the present invention is not limited to the embodiments described above, and can be embodied in various aspects.

In the embodiments described above, the protruding portion 37 of the heat conduction portion 36 is in contact with the high-frequency circuit 20 directly or via an indirect member. However, instead of or in addition to this, another part of the heat conduction portion 36 may be in contact with the high-frequency circuit 20 directly or via an indirect member. In short, in any way, the heat conduction portion 36 may be in contact with the high-frequency circuit 20 directly or via an indirect member. In the embodiments described above, the protruding portion 50 of the heat conduction portion 36 is in contact with the ground G. However, instead of or in addition to this, another part of the heat conduction portion 36 may be in contact with the ground G. In short, the heat conduction portion 36 may be in contact with the ground G in any way. In the embodiments described above, the transmission portion 34 and the heat conduction portion 36 are integrally formed by insert molding or outsert molding. However, the transmission portion 34 and the heat conduction portion 36 may be formed by any known method respectively.

According to the present invention, it is possible to provide a vehicle radar apparatus in which the heat radiation performance can be improved.

## Claims

1. A vehicle radar apparatus (1, 1B, 1C) comprising:
an antenna board (10) provided with an antenna unit (12) configured to transmit and receive a radio wave on one side surface (11a);
a high-frequency circuit (20) provided on said side surface (11a) of the antenna board (10) and configured to generate the radio wave to be transmitted and perform processing of the received radio wave; and
a case (30) configured to accommodate the antenna board (10) and the high-frequency circuit (20),
wherein the case (30) includes a cover portion (31) that is provided so as to cover said side surface (11a) of the antenna board (10),
wherein the cover portion (31) includes:
a transmission portion (34) configured to transmit the radio wave, and
a heat conduction portion (36) having a thermal conductivity higher than a thermal conductivity of the transmission portion (34), and
wherein the heat conduction portion (36) is configured to be in contact with the high-frequency circuit (20) directly or via an indirect member (41) having a thermal conductivity higher than the thermal conductivity of the transmission portion (34).

2. The vehicle radar apparatus (1C) according to Claim 1,
wherein the heat conduction portion (36) is electrically connected to a ground (G) of the antenna board (10).
